(19) Europäisches Patentamt / European Patent Office / Office européen des brevets

(11) EP 2 446 487 B1

(12) **EUROPEAN PATENT SPECIFICATION**

(45) Date of publication and mention
of the grant of the patent:
**13.07.2016 Bulletin 2016/28**

(51) Int Cl.:
**C09K 11/79** *(2006.01)* **H01L 33/50** *(2010.01)*

(21) Application number: **10797236.6**

(22) Date of filing: **26.05.2010**

(86) International application number:
**PCT/KR2010/003302**

(87) International publication number:
**WO 2011/004961 (13.01.2011 Gazette 2011/02)**

(54) **LIGHT EMITTING DEVICE EMPLOYING LUMINESCENT SUBSTANCES WITH OXYORTHOSILICATE LUMINOPHORES**

LICHTEMITTIERENDE VORRICHTUNG MIT LUMINESZIERENDEN SUBSTANZEN MIT OXYORTHOSILICAT-LEUCHTSTOFFEN

DISPOSITIF ÉLECTROLUMINESCENT EMPLOYANT DES SUBSTANCES LUMINESCENTES DOTÉES DE LUMINOPHORES D OXYORTHOSILICATE

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **01.09.2009 KR 20090081949**
**24.06.2009 DE 102009030205**

(43) Date of publication of application:
**02.05.2012 Bulletin 2012/18**

(73) Proprietor: **Seoul Semiconductor Co., Ltd.**
**Seoul 153-801 (KR)**

(72) Inventors:
• **LEE, Chung Hoon**
**Ansan-si**
**Gyeonggi-do 425-851 (KR)**

• **TEWS, Walter**
**17489 Greifswald (DE)**
• **ROTH, Gundula**
**17489 Levenhagen (DE)**
• **STARICK, Detlef**
**17489 Greifswald (DE)**

(74) Representative: **Stolmár & Partner**
**Patentanwälte PartG mbB**
**Blumenstraße 17**
**80331 München (DE)**

(56) References cited:
JP-A- 2006 173 433    JP-A- 2007 186 674
KR-A- 20060 034 056   KR-A- 20080 046 789
US-A1- 2006 261 309   US-A1- 2008 083 906
US-A1- 2009 072 255

**Description**

**Technical Field**

Exemplary embodiments of the invention relate to a light emitting device employing inorganic silicate-based luminescent substances as a radiation converter. The light emitting device can emit colored or white light by employing the luminescent substances, which can be used as a radiation converter for converting higher-energy primary radiation, for example ultra violet (UV) radiation or blue light, into a longer-wave visible radiation. The light emitting device comprising the luminescent conversion substances can be distinguished in particular for an improved temperature-dependent efficiency of the luminescence or quantum efficiency and for a longer life of the luminescent substances which can be responsible for the emission of the light produced. In particular, a high stability of the luminophores with respect to the radiation load occurring and with respect to the influence of atmospheric humidity and other environmental factors can be achieved.

**Background Art**

A light emitting device (LED) has been widely used for various applications, for example, indicators, display boards and display devices ever since the light emitting device can implement colors. White light can also have applicability for general illumination. Since such a light emitting device provides high efficiency and long life span and is ecological, this has spawned the light emitting device to continuously develop for many applications.

To promote greater adoption, manufacturers effort to develop various methods for implementing colors including white light and techniques to dispose phosphors around a light emitting diode and to combine light emitted from the light emitting diode and light emitted from the phosphors is generally accepted to implement white light.

For example, europium-activated alkaline earth metal oxyorthosilicates of the general type $Sr_3SiO_5$: Eu have become known for use in LEDs emitting colored or white light, it also being possible completely or partly to replace the element strontium in these compounds by other alkaline earth metal ions.

US 2008/0083906 A1 discloses an alkaline-earth metal silicate-based phosphor emitting orange-light and being represented by a general formula of a $(Sr_{1-x}Eu_{x(1-y)}Yb_{xy})O \cdot SiO_2$, wherein $2.9 \leq a \leq 3.1$; $0.005 \leq x \leq 0.10$ and $0.001 \leq y \leq 0.1$.

In the general formula provided Sr, Eu and Yb can substitute each other within the defined ranges. To obtain an overall compensation of charge according to the general formula $(Sr_{1-x}Eu_{x(1-y)}Yb_{xy})O$ must have an overall neutral charge. In the general formula Yb as well as Eu, can replace Sr. Since Sr is an alkaline earth metal, it has to be bivalent. Yb, as well as Eu, is known to have a valence of +3 or +2. In case Yb would have an oxidation state of +3 the additional charge has to be compensated. Since neither Sr nor Eu have a stable oxidation state of +1 and the amount of oxygen is fixed in the general formula, also Yb has to be bi-valent to obtain an overall charge compensation of the phosphor.

Although the oxidation state of Yb is not explicitly described in US 2008/0083906 A1 it nevertheless is mandatory that Yb has an oxidation state of 2+ in the general formula since otherwise it is not possible to fulfil the stoichiometric ratios of the general formula.

Thus, it is concluded that US 2008/0083906 A1 does not disclose rare earth metal oxyorthosilicates, but only alkaline earth metal oxyorthosilicates with Yb(II) replacing bivalent Sr.

In US 2006/261309 A1 is disclosed a A phosphor composition having at least two silicate-based phases, the composition comprising:

a first phase with a crystal structure substantially the same as that of $(M1)_2SiO_4$; and

a second phase with a crystal structure substantially the same as that of $(M2)_3SiO_5$; wherein:

M1 and M2 are each selected from the group consisting of Sr, Ba, Mg, Ca, and Zn;

at least one phase of the composition contains greater than or equal to about 0.0001 percent by weight Mg;

at least one phase of the composition is activated with divalent europium ($Eu^{2+}$); and

at least one of the phases of the composition contains a dopant D selected from the group consisting of F, Cl, Br, S, and N, wherein at least some of the dopant atoms are located on oxygen atom lattice sites of the host silicate crystal.

In US 2009/072255 A1 is described a A phosphor satisfying requirements (1) to (3):

(1) the phosphor satisfies Formula [2] and/or Formula [3]:

$$85 \leqq \{R_{455}(125)/R_{455}(25)\} \times 100 \leqq 110 \qquad [2]$$

$$92 \leqq \{R_{405}(125)/R_{405}(25)\} \times 100 \leqq 110 \qquad [3]$$

wherein in Formula [2], $R_{455}(25)$ represents an emission peak intensity when the phosphor is excited by light having a peak wavelength of 455 nm at 25° C., and

$R_{455}(125)$ represents an emission peak intensity when the phosphor is excited by light having a peak wavelength of 455 nm at 125° C., and wherein in Formula [3], $R_{405}(25)$ represents an emission peak intensity when the phosphor is excited by light having a peak wavelength of 405 nm at 25° C., and

$R_{405}(100)$ represents an emission peak intensity when the phosphor is excited by light having a peak wavelength of 405 nm at 100° C.,

(2) the emission peak wavelength is in the range of 570 nm to 680 nm, and

(3) the full width at half maximum of an emission peak is 90 nm or less.

## Disclosure

## Technical Problem

However, acknowledged disadvantage of luminescent substances is that they have a comparatively short life under conditions of use. This is due in particular under the high moisture sensitivity of the europium-doped alkaline earth metal oxyorthosilicates.

Therefore, there is a need for an approach for reducing a substantial disadvantage which may cause completely prevent a technical applicability of the luminophores or at least limit the disadvantages to a considerable extent.

## Technical Solution

These and other needs are addressed by the present invention, in which exemplary embodiments of the invention provide light emitting devices including chemically modified oxyorthosilicate luminescent substances having improved properties, in particular having a substantially increased stability to atmospheric humidity.

Additional features of the invention will be set forth in the description which follows, and in part will be apparent from the description, or may be learned by practice of the invention.

Still other aspects, features, and advantages of the present invention are readily apparent from the following detailed description, simply by illustrating a number of particular embodiments and implementations, including the best mode contemplated for carrying out the present invention. The present invention is also capable of other and different embodiments, and its several details can be modified in various obvious respects, all without departing from the spirit and scope of the present invention. Accordingly, the drawing and description are to be regarded as illustrative in nature, and not as restrictive.

Exemplary embodiments of the present invention disclose a light emitting device.

The light emitting device is comprising
a light emitting diode; and
luminescent substances disposed around the light emitting diode to absorb at least a portion of light emitted from the light emitting diode and to emit light having different wavelength from that of the absorbed light, wherein the luminescent substances comprise $Eu^{2+}$- doped silicate luminophores comprising solid solutions of mixed phases between alkaline earth metal oxyorthosilicates and rare earth metal oxyorthosilicates used as base lattices for the $Eu^{2+}$ activation leading to luminescence.

It is to be understood that both the foregoing general description and the following detailed description are exemplary and explanatory and are intended to provide further explanation of the invention as claimed.

**Description of Drawings**

The accompanying drawings, which are included to provide a further understanding of the invention and are incorporated in and constitute a part of this specification, illustrate exemplary embodiments of the invention, and together with the description serve to explain the principles of the invention.

FIG. 1 is a cross-sectional view of a light emitting device 100 according to exemplary embodiments of the present invention.

FIG. 2 is a cross-sectional view of a light emitting device 200 according to exemplary embodiments of the present invention.

FIG. 3 is a cross-sectional view of a light emitting device 300 according to exemplary embodiments of the present invention.

FIG. 4 is a cross-sectional view of a light emitting device 400 according to exemplary embodiments of the present invention.

FIG. 5 is a cross-sectional view of a light emitting device 500 according to exemplary embodiments of the present invention.

FIG. 6 is a graph showing the X-ray diffraction diagrams of different luminescent substances.

FIG. 7 is a graph showing the emission spectra of inventive luminescent substances of different composition.

**Mode for the Invention**

A light emitting device employing luminescent substances including chemically modified oxyorthosilicate luminescent substances is described. In the following description, for the purposes of explanation, numerous specific details are set forth in order to provide a thorough understanding of the present invention. It is apparent, however, to one skilled in the art that the present invention may be practiced without these specific details or with an equivalent arrangement. In other instances, well-known structures and devices are shown in block diagram form in order to avoid unnecessarily obscuring the present invention.

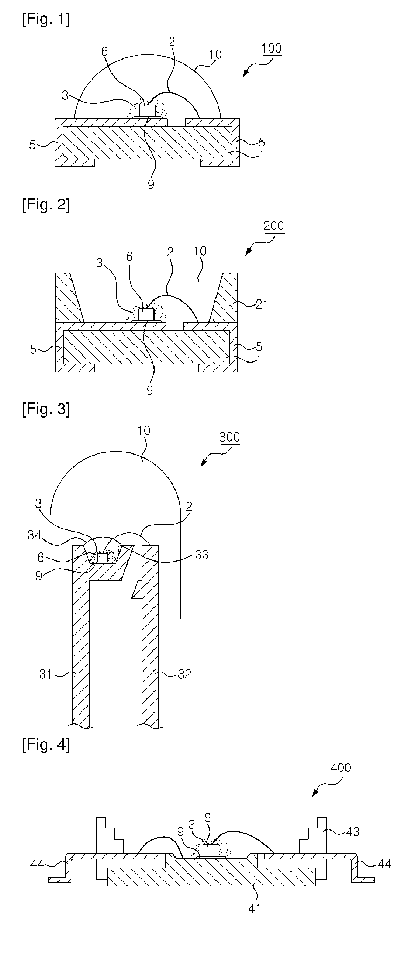

FIG. 1 is a cross-sectional view of a light emitting device 100 according to exemplary embodiments of the present invention. FIG. 1 shows a chip-type package comprising at least one light emitting diode and luminescent substances.

Referring to FIG. 1, electrodes 5 may be formed on both sides of substrate 1. Light emitting diode 6 emitting primary light may be mounted on one of the electrodes 5. The light emitting diode 6 may be mounted on one electrode 5 via electrically conductive paste 9, such as Ag paste, and be connected to other electrode 5 via, for example, an electrically conductive wire 2.

The light emitting diode 6 may emit ultraviolet or blue light and can be fabricated of gallium nitride based composite semiconductor. Especially, the light emitting diode 6 may emit blue light.

Luminescent substances 3 may be placed on a portion of the top and side faces of the light emitting diode 6. And, the light emitting diode 6 may be sealed with a molding member 10, for example, thermosetting resin. The luminescent substances 3 may be placed near the light emitting diode 3, but can be placed any location by way of configuration. The luminescent substances 3 can also be uniformly distributed in the molding member 10.

The luminescent substances 3, while being disposed around the light emitting diode 6, can adsorb at least a portion of the light emitted from the light emitting diode or emit light having a different wavelength from the absorbed light. The luminescent substances 3 can be a silicate material having $Eu^{2+}$-doped luminophores in which solid solutions, so-called mixed phases, between the alkaline earth metal oxyorthosilicates and rare earth metal oxyorthosilicates can be used as base lattices for the $Eu^{2+}$ activation leading to luminescence. The luminescent substances 3 will be described below in detail.

Light emitting diode 6 may be electrically connected to an external power supply via electrodes 5, and thus can emit primary light. The luminescent substances 3 may absorb at least a portion of the primary light and emit secondary light of a wavelength longer than that of the primary light. As a result, the primary light emitted from the light emitting diode 6 and the secondary light from the luminescent substances 3 can be mixed together, and the mixed light can be emitted from the light emitting device. A desired color of light, for example white light, may be implemented using this mixed light.

The light emitting device 100 may comprise two or more light emitting diodes. These light emitting diodes may have same emission peaks to one another, or may have different emission peaks from one another. For example, the light emitting device 100 may comprise the same or different light emitting diodes each of which can emit ultraviolet or blue light. Furthermore, the light emitting device 100 may comprise a light emitting diode, for example, a red light emitting diode, which can emit light with a wavelength longer than the emission peak wavelength of the phosphors. Such a longer wavelength light emitting diode may be employed for improving a color rendering index of the light emitting device 100. Moreover, the light emitting device 100 may further comprise other phosphors in addition to the luminescent substances 3. The other phosphors may comprise orthosilicate phosphors, Yttrium Aluminum Garnet (YAG) based phosphors or thiogallate phosphors, but it is not limited thereto. Accordingly, a desired light of color can be achieved with proper selection of the light emitting diode 6 and phosphors.

FIG. 2 is a cross-sectional view of a light emitting device 200 according to exemplary embodiments of the present invention. FIG. 2 shows exemplary top-view of package having a reflector 21.

Referring to Fig. 2, the light emitting device 200 may have a similar structure as that of the above light emitting device 100, and may have a reflector 21 on the substrate 1. A light emitting diode 6 can be mounted in the reflector 21. The reflector 21 is provided to reflect light emitted from the light emitting diode 6 to increase brightness within a certain angle of view.

For example, as described with reference to Fig. 1, luminescent substances 3, while being disposed around the light emitting diode 6, may adsorb at least a portion of the light emitted from the light emitting diode or emitted light having a different wavelength from the absorbed light. The luminescent substances 3 can be dotted on the light emitting diode 6 in the reflector 21 or can uniformly be distributed within a thermosetting resin molding member 10. The luminescent substances 3 will be described below in detail.

The light emitting device 200 may also comprise two or more light emitting diodes having same emission peaks to one another, or different emission peaks from one another, and may further comprise other phosphors in addition to the luminescent substances 3, as described with reference to FIG. 1.

In some examples, the light emitting device 100 or 200 as shown in the FIG. 1 or FIG. 2 can include a substrate of a metallic material, for example a metal printed circuit board (PCB,) which has good heat conductivity. Such a substrate may easily dissipate the heat from the light emitting diode 6. Furthermore, a lead frame including lead terminals may be used as the substrate. Such a leadframe may be surrounded and supported by the molding member 10 to encapsulate the light emitting diode.

As seen in FIG. 2, the reflector 21 may be formed of a different material from the substrate 1, but not limited thereto. For example, the reflector 21 may also be formed of the same material as the substrate 1. A lead frame having lead terminals can be insert-molded of a plastic, such as a polyphthalamide (PPA,) which can form the substrate 1 and the reflector 21 together. Then, the lead terminals can be bent to form electrodes 5.

FIG. 3 is a cross-sectional view of a light emitting device 300 according to exemplary embodiments of the present invention. It is contemplated that the light emitting device 300 may have been known as a light emitting diode ramp.

Referring to FIG. 3, the light emitting device 300 may have a pair of lead electrodes 31, 32, and a cup portion 33 having a shape of cup formed at a portion of the upper end of one lead electrode 31. At least one light emitting diode 6 may be mounted in the cup portion 33, and may electrically be connected to the other lead electrode 32 via a conductive wire 2. When a plurality of light emitting diodes is mounted in the cup portion 33, they may emit light of same wavelength or different wavelengths from one another.

Further, luminescent substances 3 may be disposed around the light emitting diode 6. As described with reference to FIG. 1, the luminescent substances 3, while being disposed around the light emitting diode 6, may adsorb at least a portion of the light emitted from the light emitting diode and emit light having a different wavelength from that of the absorbed light. The luminescent substances 3 can be dotted on the light emitting diode 6 in the cup portion 33 or uniformly be distributed within a thermosetting resin molding member 34 formed in the cup portion 33. The luminescent substances 3 will be described below in detail.

A molding member 10 may encapsulate the light emitting diode 6, the luminescent substances, and a portion of the respective pair of lead electrodes 31 and 32. The molding member 10 may be formed of epoxy or silicone, as an example.

The light emitting device 300 may be provided to have a pair of lead electrodes 31 and 32. However, the light emitting device 300 may have more lead electrodes than the pair of lead electrodes 31 and 32.

FIG. 4 is a cross-sectional view of a light emitting device 400 according to exemplary embodiments of the present invention. FIG. 4 may show a light emitting diode package for high power.

Referring to Fig. 4, the light emitting device 400 may comprise a heat-sink 41 provided in a housing 43. The bottom surface of the heat sink 41 can be exposed to outside. Lead electrodes 44 can be exposed within the housing 43, and extended through the housing. At least one light emitting diode 6 can be mounted on the upper surface of the heat-sink 41 via an electrically conductive adhesive 9, and electrically be connected to one of the lead electrodes 44 via a electrically conductive wire. Furthermore, another electrically conductive wire may connect the other lead electrode 44 to the heat-sink 41, such that the light emitting diode 6 can electrically be connected to each of the two lead electrodes 44.

In some examples, luminescent substances 3 can be disposed around the light emitting diode 6 on the heat-sink 41. As described with reference to FIG. 1, the luminescent substances 3, while being disposed around the light emitting diode 6, may adsorb at least a portion of the light emitted from the light emitting diode and emit light having a different wavelength from that of the absorbed light. The luminescent substances 3 can be dotted on the light emitting diode 6 on the heat-sink 41, or uniformly be distributed within a molding member (not shown) to cover the light emitting diode. The luminescent substances 3 will be described below in detail.

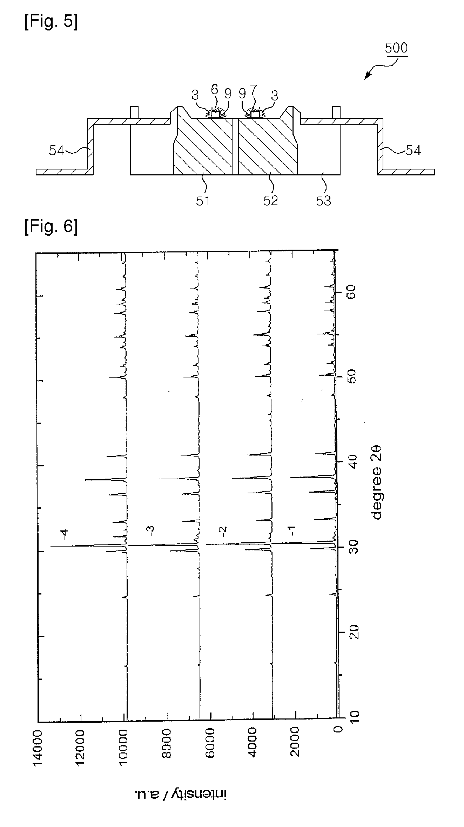

FIG. 5 is a cross-sectional view of a light emitting device 500 according to exemplary embodiments of the present invention.

Referring to FIG. 5, the light emitting device 500 comprises a housing 53 and a plurality of heat-sinks 51 and 52 which can be joined to the housing and insulated from each other. Light emitting diodes 6 and 7 can be mounted on the heat-sinks 51 and 52 via electrically conductive adhesives, and electrically be connected to lead electrodes 54 via electrically conductive wires (not shown), respectively. The lead electrodes 54 can be extended from inside of the housing 53 to outside. As for the illustration only, two lead electrodes 54 are shown in FIG. 5, but more lead electrodes may be provided thereto.

For example, luminescent substances 3 may be disposed around at least one of the light emitting diodes 6 or 7, as described with reference to FIG. 4. The luminescent substances 3 will be described below in detail.

In the above embodiments of the present invention, it is contemplated that the light emitting diode 6 can be mounted on the substrate 1 or on the heat-sink via the electrically conductive adhesive 9, and electrically connected to the electrode or lead electrode via the electrically conductive wire. Those of ordinary skill in the art will recognize that embodiments may be limited when the light emitting diode 6 is a "single-bond die", which has its electrodes on the top side and bottom side thereof, respectively. It is observed that where the light emitting diode 6 is a "two-bond die", which has two electrodes on the top side thereof, the light emitting diode 6 may be electrically connected to the electrodes or lead electrodes via two electrically conductive wires, respectively. In this example, the adhesive need not to be electrically conductive.

In some examples, the light emitting diode 6 may be formed of (Al, Ga, In)N based composite semiconductor.

The light emitting diode 6 may have, for example, a double heterostructure, a single quantum well structure or multi-quantum well structures, which may have a single active region between n-type and p-type semiconductor layers.

By way of example, the light emitting diode 6 may comprise a plurality of light emitting cells spaced apart from one another on a single substrate. Each of the light emitting cells may comprise an active region, and these light emitting cells may be connected to one another in series and/or in parallel via wires such that the light emitting cells can be directly driven by an alternating current (AC) power supply. Such an AC-light emitting diode can be driven in connection to AC power supply without outer AC-DC converter by forming a bridge rectifier and a series array of light emitting cells connected to the rectifier, or by forming series arrays of light emitting cells on a single substrate, these arrays being electrically connected to one another in anti-parallel. The operating voltage of the AC-light emitting diode can be increased up to the voltage for domestic use, for example, 110V or 220V, since the light emitting cells are connected in series. As such, a light emitting device, which can be driven by domestic power supply, can be provided.

In some examples, the luminescent substances 3 may be disposed between the light emitting diode 6 and the substrate 1, the heat-sink on which the light emitting diode can be mounted, or may be distributed within the adhesive 9. These luminescent substances 3 may adsorb at least a portion of the light emitted downward from the light emitting diode 6 or emitted light having a different wavelength from the absorbed light.

Although several structures for the light emitting device have been described above, the present invention may not limited these structures, and the structure of the light emitting device of the present invention can be modified based on types of the light emitting diodes, an electrical connection method thereof, a desired angle view of light, and the purpose of using the light emitting device.

Now, luminescent substances used in the embodiments of the invention are described.

This group of luminescent substances may comprise $Eu^{2+}$-doped silicate luminophores for which solid solutions, so-called mixed phases, between alkaline earth metal oxyorthosilicates and rare earth metal oxyorthosilicates can be used as base lattices. The solid solution formation, between the two different oxyorthosilicate types, can be possible within certain concentration limits and has been detected are characterized by the following notation:

$$(1-x)M^{II}_3SiO_5 \cdot xSE_2SiO_5.$$

In a general structural formula, $M^{II}$ preferably can represent the alkaline earth metal ion of Sr or represent another alkaline earth metal ion or another divalent metal ion selected from the group of the elements magnesium, calcium, barium, copper, zinc and manganese, and these ions may be used in defined amounts, as a rule, in addition to the strontium and also as mixtures with one another. In a barium case, complete replacement of the strontium can be possible. The proportion of the other divalent metal ions can be incorporated in addition to the strontium may be up to 0.5.

The symbol SE used in the general formula represents rare earth metals and designates the trivalent metal ions of yttrium, of lanthanum and of the so-called lanthanoids, i.e., elements having atomic numbers 58 to 71, but preferably the corresponding ions of the elements yttrium, lanthanum, gadolinium and lutetium. These ions can be incorporated as individual components or as mixtures with one another into the matrix.

Apart from europium and in addition to this doping element, in principle, further divalent rare earth metal ions, for example, those of samarium, ytterbium or certain trivalent rare earth metal ions, such as, for example, cerium ions ($Ce^{3+}$) can also be used in principle as activators.

For the purpose of optimizing the luminescence properties and the stability characteristics, even further modifications may be possible based on the composition of the luminescent substances according to the invention. In some examples, the silicon can be replaced by germanium and/or by aluminium, gallium, boron or phosphorus, it may be necessary, however, to take a proper measurement for preserving the charge balance. These may consist, for example, in addition to incorporating further monovalent cations, incorporate lithium, sodium or potassium, or anions, such as fluorine, chlorine, bromine or iodine, into the base lattices.

By way of example, the luminescent substances according to the invention have the following formula:

$$(1-x)\ (Sr_{3-a-b-z}Ba_aCa_bM^{II}{}_cEu_z)SiO_5 \cdot xSE_2SiO_5,$$

where $M^{II}$ = Mg, Cu, Zn and/or Mn, and
SE = Y, La, Gd and/or Lu and/or another element selected from the group consisting of the lanthanoids with the atomic numbers 58 to 71,
and the molar proportions

$$x \leq 0.2, \text{ in particular } x \leq 0.1,$$

$$0 \leq a \leq 3,\ 0 \leq b \leq 0.05,\ 0 \leq c \leq 0.5$$

and $z \leq 0.25$.

$$z \leq 0.25.$$

According to exemplary embodiments of the present invention, alkaline earth metal and rare earth metal oxyorthosilicates can form, within certain concentration limits, solid solutions, the crystalline mixed phases, with one another, and the $Eu^{2+}$ activation of such base lattices can lead to efficient luminescent substances having substantially improved moisture stability. The concentration range for the solid solution formation may be up to 15 mol% of rare earth metal oxyorthosilicate.

On excitation with high-energy radiation, the luminescent substances according to the invention emit in the visible part of the spectrum, preferably in the range between 560 nm and 620 nm, depending on their specific chemical composition. The excitability of the $Eu^{2+}$ luminescence may extend from 220 nm in the UV range up to 550 nm in the visible range, which means that the inventive luminophores can be excited even with green excitation radiation to give an efficient yellow to orange or red luminescence.

The preparation of the luminescent substances can be effected based on multistage high-temperature solid-state reactions occurred between the alkaline earth metal and rare earth metal carbonates preferably used as starting material or the corresponding oxides and colloidal $SiO_2$, it may be possible to add certain amounts of fluxes or mineralization additives, for example, $NH_4Cl$, certain alkali metal or alkaline earth metal fluorides to the reaction mixture to promote the reactivity and to control the particle size distribution of the resulting luminophores. These starting materials may thoroughly be mixed and then ignited for 1 to 48 hours at temperatures of 1300 to 1700°C in an inert or reducing atmosphere. The main ignition process for the purpose of optimizing the properties of the luminescent substances can optionally have a plurality of ignition stages in different temperature ranges. After the end of the ignition process, the samples can be cooled to room temperature and subjected to suitable posttreatment processes which design, for example, for the elimination of flux residues, the minimization of surface defects or the fine adjustment of the particle size distribution.

Instead of the colloidal silica, silicon nitride ($Si_3N_4$) can also alternatively be used as a reactant for the reaction with the alkaline earth metal and rare earth metal compounds may be used. It is also possible to prepare the respective individual alkaline earth metal or rare earth metal oxyorthosilicate components separately from one another and then to ensure the solid solution formation by repeated thermal treatment in a temperature range suitable for the purpose.

Detailed information of the preparation of the luminescent substances can be described below with reference to a plurality of working examples.

(Example 1)

Example 1 describes a preparation of a strontium oxyorthosilicate luminescent substance having the composition $(Sr_{2.95}Ba_{0.01}Eu_{0.04})$ $SiO_5$, which is regarded as reference material for evaluating the advantages of the inventive luminescent substances.

For the preparation of luminescent substance, approximately 217.75g of $SrCO_3$, 0.99g of $BaCO_3$, 3.52g of $Eu_2O_3$ and 31.54g of $SiO_2$ and 2.68g of $NH_4Cl$ can be thoroughly mixed and then ignited for about 4 hours at a temperature of approximately 1350°C in a forming gas atmosphere. After the end of the ignition process, the ignited material can be homogenized by milling and then subjected again to a thermal treatment at approximately 1350°C for about two hours in reducing $N_2/H_2$ atmosphere having a hydrogen concentration of at least about 5%. The aftertreatment of the cooled ignited material may include the milling thereof, the carrying out of washing processes and the drying and sieving of the end products.

(Example 2)

Example 2 describes the synthesis of the luminescent substance having the composition $0.99 \cdot (Sr_{2.95}Ba_{0.01}Eu_{0.04})SiO_5 \cdot 0.01 \cdot Y_2SiO_5$. This luminescent substance can be prepared while maintaining the ignition conditions described in Example 1, the following starting materials and amounts can be used: 215.58g of $SrCO_3$, 0.98g of $BaCO_3$, 1.13g of $Y_2O_3$, 3.47g of $Eu_2O_3$, 31. 54g of $SiO_2$ and 2.68g of $NH_4Cl$.

(Example 3)

In the preparation of the luminescent substance having the composition $0.95 \cdot (Sr_{2.8875}Ba_{0.01}Cu_{0.0025}Eu_{0.10})SiO_5 \cdot 0.05 \cdot Gd_2SiO_5$, 202.48g of $SrCO_3$, 0.94g of $BaCO_3$, 0.094g of CuO, 9.06g of $Gd_2O_3$, 8.36g of $Eu_2O_3$ and 30.94g of $SiO_2$ can be used as starting materials in Example 3, to which 4.0g of $NH_4Cl$ can be added as a flux. After thorough homogenization, the starting mixture can be transferred to corundum crucibles, which can be positioned in a high temperature furnace. In this example, the solid mixtures may be subjected to an ignition regime which has a first 10 hour holding stage at approximately 1200°C, a second 5 hour holding stage at approximately 1550°C and a third holding stage at approximately 1350°C, the residence time in the last stage being 2 hours. The ignitions are effected in pure nitrogen until approximately 1550°C ramp has been reached, in an $N_2/H_2$ mixture with 20% hydrogen during the approximately 1550°C phase and then in forming gas (5% hydrogen), cooling being effected by the greatest possible speed after the end of the approximately 1350°C ignition stage. The aftertreatment of the samples of the luminescent substance can be effected in the manner described in Example 1.

(Example 4)

Preparation variant according to Example 4 comprises preparing the modified strontium oxyorthosilicates and the rare earth metal oxyorthosilicates separately from one another and then apply the solid solution formation in a separate production step. The resulting luminescent substance has the composition $0.995 \cdot (Sr_{2.498}Ba_{0.45}Ca_{0.002}Eu_{0.05})SiO_5 \cdot 0.005 \cdot La_2SiO_5$.

The synthesis of the $(Sr_{2.498}Ba_{0.45}Ca_{0.002}Eu_{0.05})SiO_5$, component can be applied analogously to Example 1 by utilizing the following amounts: 184.39g of $SrCO_3$, 44.40g of $BaCO_3$, 0.078g of $CaF_2$, 3.96g of $Eu_2O_3$ and 31.54g of $SiO_2$. The required lanthanum oxyorthosilicate $La_2SiO_5$ can be prepared in a one-stage ignition process with the use of 325.81 g of $La_2O_3$, 55.2 g of $SiO_2$ and 2.68 g of $NH_4Cl$, then the thoroughly mixed starting materials is ignited for about 6 hours at temperatures of approximately 1380°C in forming gas.

For the production of the luminescent substance in its composition, 197.23g of the prepared $(Sr_{2.498}Ba_{0.45}Ca_{0.002}Eu_{0.05})SiO_5$ component and 0.96g of $La_2SiO_5$ may be subjected to a thorough mixing procedure and then heated for about 6 hours at approximately 1150°C in a nitrogen-hydrogen (5%) stream.

FIG. 6 is a graph showing the X-ray diffraction diagrams of luminescent substances whose preparations are described in Working Examples 1 through 4. It should be understood that the reflections of $Sr_3SiO_5$ are known from the literature, the diffraction angles can be shifted slightly compared with the pure $Sr_3SiO_5$ phase due to the lattice substitutions being carried out. Indications of the presence of reflections which could be assigned to the monoclinic $SE_2SiO_5$ phases may not detectable in any of the diagrams. Such reflections actually may occur only on the outside of the stated concentration limits for the formation of solid solutions between the strontium oxyorthosilicate and the corresponding rare earth metal oxyorthosilicates.

Table 1

[Table 1]

| Material | Lattice constants | |
|---|---|---|
| | a = b | c |
| | | |
| Commercially available $Sr_3SiO_5$ : Eu | 6.962 | 10.771 |
| | | |
| $(Sr_{2.95}Ba_{0.01}Eu_{0.04})SiO_5$ - reference | 6.957 | 10.770 |
| | | |
| 0.99 $(Sr_{2.95}Ba_{0.01}Eu_{0.04})SiO_5$ - 0.01 $Y_2SiO_5$ | 6.955 | 10.769 |
| 0.975 $(Sr_{2.95}Ba_{0.01}Eu_{0.04})SiO_5$ - 0.025 $Y_2SiO_5$ | 6.958 | 10.770 |
| 0.95 $(Sr_{2.95}Ba_{0.01}Eu_{0.04})SiO_5$ - 0.05 $Y_2SiO_5$ | 6.954 | 10.766 |
| | | |
| 0.98 $(Sr_{2.95}Ba_{0.01}Eu_{0.04})SiO_5$ - 0.02 $Gd_2SiO_5$ | 6.957 | 10.770 |
| 0.95 $(Sr_{2.95}Ba_{0.01}Eu_{0.04})SiO_5$ - 0.05 $Gd_2SiO_5$ | 6.958 | 10.773 |
| 0.925 $(Sr_{2.95}Ba_{0.01}Eu_{0.04})SiO_5$ - 0.075 $Gd_2SiO_5$ | 6.956 | 10.769 |
| | | |
| 0.995 $(Sr_{2.95}Ba_{0.01}Eu_{0.04})SiO_5$ - 0.005 $La_2SiO_5$ | 6.954 | 10.767 |
| 0.99 $(Sr_{2.95}Ba_{0.01}Eu_{0.04})SiO_5$ - 0.01 $La_2SiO_5$ | 6.957 | 10.768 |
| 0.975 $(Sr_{2.95}Ba_{0.01}Eu_{0.04})SiO_5$ - 0.025 $La_2SiO_5$ | 6.957 | 10.769 |

TABLE. 1 enumerates the lattice constants of further luminescent substances according to exemplary embodiments of the invention which can be prepared analogously to the method stated in Example 2. The lattice constants of the luminophores are very similar to one another. In view of the comparatively small proportions of $SE_2SiO_5$ in the oxyorthosilicate solid solutions used as base lattices of the luminescent substances, no clear trends can be detectable for the variation of the lattice constants.

In TABLE. 2, indications of solid solution formation between the differing oxyorthosilicate lattices are evident from the listed luminescence parameters of the luminescent substances according to exemplary embodiments of the invention. For example, the systematic shifts of the color coordinates and of the full widths at half maximum of the emissions spectra, which can be registered with an increasement of proportion of $SE_2SiO_5$, are a safe indication of the formation of solid solutions. Differences may occur when incorporation of yttrium oxyorthosilicate or gadolinium oxyorthosilicate on the one hand and lanthanum oxyorthosilicate on the other hand. The differences may inevitable due to the differences in the ionic radii of the respective rare earth elements.

The luminescence efficiencies of the inventive luminescent substances and the temperature dependencies thereof show improvements compared with the known $Sr_3SiO_5$: Eu luminescent substances.

Table 2

[Table 2]

| Material | Powder Intensity 450nm excitation | Color coordinates | | FWHM | Intensity 150°C |
|---|---|---|---|---|---|
| | % | x value | y value | nm | % |
| | | | | | |
| Commercially available $Sr_3SiO_5$ : Eu | 98.3 | | | | 91.3 |
| | | | | | |
| $(Sr_{2.95}Ba_{0.01}Eu_{0.04})SiO_5$ - reference | 100 | 0.5373 | 0.1604 | 68.1 | 91.5 |
| | | | | | |

(continued)

| Material | Powder Intensity 450nm excitation | Color coordinates | | FWHM | Intensity 150°C |
|---|---|---|---|---|---|
| | % | x value | y value | nm | % |
| 0.99 $(Sr_{2.95}Ba_{0.01}Eu_{0.04})SiO_5$ - 0.01 $Y_2SiO_5$ | 99.6 | 0.5371 | 0.4604 | 69.5 | 91.4 |
| 0.975 $(Sr_{2.95}Ba_{0.01}Eu_{0.04})SiO_5$ - 0.025 $Y_2SiO_5$ | 100.8 | 0.5362 | 0.4611 | 70.5 | 92.5 |
| 0.95 $(Sr_{2.95}Ba_{0.01}Eu_{0.04})SiO_5$ - 0.05 $Y_2SiO_5$ | 98.7 | 0.5343 | 0.4629 | 70.9 | 92.1 |
| | | | | | |
| 0.98 $(Sr_{2.95}Ba_{0.01}Eu_{0.04})SiO_5$ - 0.02 $Gd_2SiO_5$ | 101.3 | 0.5361 | 0.4614 | 70.1 | 93.2 |
| 0.95 $(Sr_{2.95}Ba_{0.01}Eu_{0.04})SiO_5$ - 0.05 $Gd_2SiO_5$ | 100.2 | 0.5358 | 0.4615 | 71.3 | 91.4 |
| 0.925 $(Sr_{2.95}Ba_{0.01}Eu_{0.04})SiO_5$ - 0.075 $Gd_2SiO_5$ | 97.9 | 0.5346 | 0.4625 | 72.7 | 92.0 |
| | | | | | |
| 0.995 $(Sr_{2.95}Ba_{0.01}Eu_{0.04})SiO_5$ - 0.005 $La_2SiO_5$ | 102.0 | 0.5377 | 0.4602 | 68.5 | 87.6 |
| 0.99 $(Sr_{2.95}Ba_{0.01}Eu_{0.04})SiO_5$ - 0.01 $La_2SiO_5$ | 102.5 | 0.5382 | 0.4596 | 68 | 87.2 |
| 0.975 $(Sr_{2.95}Ba_{0.01}Eu_{0.04})SiO_5$ - 0.025 $La_2SiO_5$ | 99.2 | 0.5352 | 0.4624 | 67.9 | 87 |

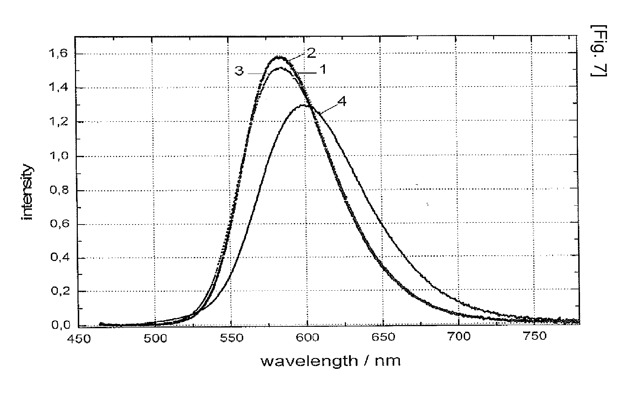

The results listed in TABLE. 2 show that, according to preparation methods, the luminescent substances can be prepared with comparable or somewhat higher luminescence efficiencies. In FIG. 7, the emissions spectra of the luminescent substances according to exemplary embodiments of the invention, of Examples 1 through 4, are shown together.

For assessing the moisture stability of the materials, the corresponding samples of luminescent substances can be stored for a period of 7 days at a temperature of 85°C and 85% relative humidity in a conditioned chamber. Thereafter, the luminophores can be dried at 150°C and then subjected to a comparative measurement of the luminescence efficiency. Exemplary results of such investigations are listed in TABLE. 3.

Table 3

[Table 3]

| Material | Powder Intensity 450nm excitation | Intensity 150°C | Intensity after moistening test |
|---|---|---|---|
| | % | % | % |
| | | | |
| Commercially available $Sr_3SiO_5$:Eu | 98.3 | 91.3 | 69.3 |
| | | | |
| $(Sr_{2.95}Ba_{0.01}Eu_{0.04})SiO_5$ - reference | 100 | 91.6 | 72.0 |
| | | | |
| 0.99 $(Sr_{2.95}Ba_{0.01}Eu_{0.04})SiO_5$ - 0.01 $Y_2SiO_5$ | 99.6 | 91.4 | 93.6 |

(continued)

| Material | Powder Intensity 450nm excitation | Intensity 150°C | Intensity after moistening test |
|---|---|---|---|
| | % | % | % |
| 0.975 $(Sr_{2.95}Ba_{0.01}Eu_{0.04})SiO_5$ - 0.025 $Y_2SiO_5$ | 100.8 | 92.5 | 95.1 |
| 0.95 $(Sr_{2.95}Ba_{0.01}Eu_{0.04})SiO_5$ - 0.05 $Y_2SiO_5$ | 98.7 | 92.1 | 91.3 |
| | | | |
| 0.98 $(Sr_{2.95}Ba_{0.01}Eu_{0.04})SiO_5$ - 0.02 $Gd_2SiO_5$ | 101.3 | 93.2 | 89.7 |
| 0.95 $(Sr_{2.95}Ba_{0.01}Eu_{0.04})SiO_5$ - 0.05 $Gd_2SiO_5$ | 100.2 | 91.4 | 94.2 |
| 0.925 $(Sr_{2.95}Ba_{0.01}Eu_{0.04})SiO_5$ - 0.075 $Gd_2SiO_5$ | 97.9 | 92.0 | 95.3 |
| | | | |
| 0.995 $(Sr_{2.95}Ba_{0.01}Eu_{0.04})SiO_5$ - 0.005 $La_2SiO_5$ | 102.0 | 87.6 | 90.3 |
| 0.99 $(Sr_{2.95}Ba_{0.01}Eu_{0.04})SiO_5$ - 0.01 $La_2SiO_5$ | 102.5 | 87.2 | 88.8 |
| 0.975 $(Sr_{2.95}Ba_{0.01}Eu_{0.04})SiO_5$ - 0.025 $La_2SiO_5$ | 99.2 | 87 | 86.4 |

From the data shown, it is understood that both the conventional luminescent substances of the structure $Sr_3SiO_5$: Eu and the $(Sr_{2.95}Ba_{0.01}Eu_{0.04})SiO_5$ luminescent substances prepared for reference purposes have only about 70% of their original luminescence efficiency after completion of the moistening procedure. In comparison, inventive europium-doped oxyorthosilicate luminescent substances having mixed-phased base lattices comprising alkaline earth metal oxyorthosilicates and rare earth metal oxyorthosilicates have substantially improved moisture resistances. After storage in an 85°C/85% H atmosphere for seven days, luminescence efficiencies of > 90%, in the case of optimized samples of > 95%, can still be achieved.

According to exemplary embodiments of the invention a light emitting device comprising a light emitting diode to emit light of ultraviolet or visible light is disclosed. Luminescent substances can be disposed around the light emitting diode to absorb at least a portion of the light emitted from the light emitting diode and emitting light having a different wavelength from the absorbed light. Further, the light emitting device may use solid solutions, referred to as mixed phases, between the alkaline earth metal oxyorthosilicates and rare earth metal oxyorthosilicates where oxyorthosilicate luminescent substances can be formed as base lattices for the $Eu^{2+}$ activation leading to luminescence. Such a solid solution formation may lead to stabilization of the solid-state matrix and to substantially improve resistance of the corresponding luminophores to atmospheric humidity and other environmental factors. In this example, the longevity of the inventive luminescent substances and that of the light-emitting arrangement produced therefrom can be permanently improved.

The luminescent substances according to the invention can be provided by the following formula:

$$(1-x)M^{II}{}_3SiO_5 \cdot xSE_2SiO_5:Eu.$$

This group of luminescent substances comprises $Eu^{2+}$-doped silicate luminophores for which solid solutions, referred to as mixed phases, between alkaline earth metal oxyorthosilicates and rare earth metal oxyorthosilicates can be used as base lattices. The solid solution formation, between the two different oxyorthosilicate types which is possible within certain concentration limits, has been detected that can be characterized by the following notation:

$$(1-x)M^{II}{}_3SiO_5 \cdot xSE_2SlO_5.$$

In a conventional structural formula, $M^{II}$ preferably represents the alkaline earth metal ion of Sr or represents another alkaline earth metal ion or another divalent metal ion selected from the group consisting of the elements magnesium, calcium, barium, copper, zinc and manganese, and these ions can be used in defined amounts, in addition to the strontium and also as mixtures with one another. In a barium case, complete replacement of the strontium can be possible. The proportion of the other divalent metal ions incorporated in addition to the strontium may be up to about 0.5.

The symbol SE used in the general formula can represent rare earth metals and designate the trivalent metal ions of yttrium, lanthanum and lanthanoids, i.e., elements having atomic numbers 58 to 71, but preferably the corresponding ions of the elements yttrium, lanthanum, gadolinium and lutetium. These ions can be incorporated either as individual components or as mixtures with one another into the matrix.

Apart from europium and in addition to this doping element, in principle further divalent rare earth metal ions, such as, for example, those of samarium, ytterbium or certain trivalent rare earth metal ions, for example, cerium ions ($Ce^{3+}$) can also be used in principle as activators.

For the purpose of optimizing the luminescence properties and the stability behaviour, even further modifications are possible in the case of the composition of the luminescent substances according to exemplary embodiments of the invention. Thus, for example, the silicon can be replaced by germanium and/or by aluminum, gallium, boron or phosphorus, it is noted, however, taking suitable measures is necessary for preserving the charge balance in the last mentioned cases. These may further incorporate , for example, monovalent cations, lithium, sodium or potassium, or anions, for example, fluorine, chlorine, bromine or iodine into the base lattices according to the invention.

According to exemplary embodiments, the luminescent substances have a following formula:

$$(1\text{-}x)\ (Sr_{3\text{-}a\text{-}b\text{-}z}Ba_aCa_bM^{II}{}_cEu_z)SiO_5 \cdot xSE_2SiO_5,$$

where $M^{II}$ = Mg, Cu, Zn and/or Mn, and
SE = Y, La, Gd and/or Lu and/or another element selected from the group consisting of the lanthanoids with the atomic numbers 58 to 71,
and the molar proportions

$$x \leq 0.2,\ \text{in particular } x \leq 0.1,$$

$$0 \leq a \leq 3,\ 0 \leq b \leq 0.05,\ 0 \leq c \leq 0.5$$

and

$$z \leq 0.25.$$

Alkaline earth metal oxyorthosilicates and rare earth metal oxyorthosilicates not only differ from one another with regard to the nature and the charge of the respective cations but also have substantially different crystal structures. The reason for the different characteristics is that the alkaline earth metal compounds form tetragonal lattices having space group P4/ncc, whereas the rare earth metal oxyorthosilicates crystallize in the monoclinic system with the space groups P2/c and B2/b, respectively.

Both classes of compounds are suitable host lattices for doping with rare earth metal activators. The alkaline earth metal oxyorthosilicates are, as described, preferably doped with divalent ions, i.e., for example, with $Eu^{2+}$ ions, whereas of course in particular trivalent rare earth metal ions, i.e., for example, $Eu^{3+}$ or $Ce^{3+}$ activators, can be incorporated into the rare earth metal oxyorthosilicate base lattices. In this context, the luminescent substance $Y_2SiO_5$:Ce can be mentioned by way of example as a representative of this class of luminescent substance and can emit in the blue range of the visible spectrum in an extremely effective manner on excitation with ionizing or UV radiation and can therefore be used in X-ray detectors, in electron beam tubes or PDP displays.

According to exemplary embodiments of the invention, alkaline earth metal and rare earth metal oxyorthosilicates may form, within certain concentration limits, solid solutions, the crystalline mixed phases, with one another, and the $Eu^{2+}$ activation of such base lattices leads to efficient luminescent substances having substantially improved moisture stability. The concentration range for the solid solution formation may be up to about 15 mol% of rare earth metal oxyorthosilicate.

On excitation with high-energy radiation, the luminescent substances may emit in the visible part of the spectrum, preferably in the range between approximately 560 and approximately 620 nm, depending on their specific chemical composition. The excitability of the $Eu^{2+}$ luminescence may extend from approximately 220 nm in the UV range up to approximately 550 nm in the visible range, which means that the inventive luminophores can be excited even with green excitation radiation to give an efficient yellow to orange or red luminescence. Intensive and technically usable luminescence processes may occur even on irradiation of the luminescent substances with electron beams, X-ray beams or gamma radiation. Due to their luminescence properties, the luminescent substances can be used as radiation converters to convert ionizing gamma radiation or X-ray or electron beams, ultraviolet, blue or green radiation into longer-wave, visible light, that can preferably be emitted in the yellow, orange or red spectral range. They can be used in a multiplicity of technical devices, for example, in cathode ray tubes and other image-generating systems (e.g., scanning laser beam systems), in X-ray image converters, in fluorescent lamps, LEDs emitting colored and white light, in solar cells or greenhouse sheets and glasses as radiation converters alone or in combination with other luminescent substances emitting blue, green, yellow and/or red lights.

The light emitting device may implement white light or desired light of color in combination of light emitted from the light emitting diode and light emitted from the luminescent substances. For example, white light or desired light of color may be implemented by mixing light emitted from the light emitting diode and light emitted from the luminescent substances. Furthermore, other luminescent substances may be added to implement desired light of color.

The luminescent substances may be disposed on at least one of side, top or bottom faces of the light emitting diode. Further, the luminophores may be mixed into an adhesive or a molding member so that the luminophores can be disposed around the light emitting diode.

The light emitting diode and the luminescent substances may be formed within one package. In addition, other light emitting diode may be formed within the package. The other light emitting diode may emit light of the same wavelength or a different wavelength from that of the above light emitting diode. For example, the other light emitting diode may emit light of longer wavelength than the emission peak wavelength

comprise a reflector reflecting light emitted from the light emitting diode. In this example, the light emitting diode can be mounted in the reflector.

Moreover, the light emitting device may further comprise a molding member to encapsulate the light emitting diode on the substrate. The luminescent substances may be distributed in the molding member, but not limited thereto.

Further, the package may comprise a heat-sink, and the light emitting diode may be mounted on the heat-sink.

In various embodiments of the present invention, the light emitting diode may be formed of (Al, Ga, In)N based composite semiconductor.

The light emitting diode may have, for example, a double heterostructure which has a single active region, single quantum well structure or multiquantum well structure disposed between n-type and p-type semiconductor layers.

The light emitting diode may comprise a plurality of light emitting cells spaced apart from one another on a single substrate. Each of the light emitting cells comprises an active region, and these light emitting cells may be connected to one another in series and/or in parallel through wires so that the light emitting cells can be directly driven under AC power supply. Such an AC-light emitting diode can be driven in connection to AC power supply without outer AC-DC converter by forming a bridge rectifier and a series array of light emitting cells connected to the rectifier, or by forming series arrays of light emitting cells on a single substrate, these arrays being electrically connected to each other in anti-parallel.

## Claims

1. A light emitting device comprising;
   a light emitting diode; and
   luminescent substances disposed around the light emitting diode to absorb at least a portion of light emitted from the light emitting diode and to emit light having different wavelength from that of the absorbed light, wherein the luminescent substances comprise $Eu^{2+}$- doped silicate luminophores comprising solid solutions of mixed phases between alkaline earth metal oxyorthosilicates and rare earth metal oxyorthosilicates used as base lattices for the $Eu^{2+}$ activation leading to luminescence.

2. The light emitting device of claim 1, wherein the $Eu^{2+}$-doped silicate luminophores are provided according to a formula $(1-x)M^{II}_3SiO_5 \cdot x\ SE_2SiO_5$:Eu,
   wherein, the $M^{II}$ represents divalent metal ions comprising at least one selected from a group consisting of strontium ion and barium ion and SE represents rare earth metals.

3. The light emitting device of claim 2, wherein the $M^{II}$ comprises at least one divalent metal ion selected from a group consisting of Mg, Ca, Cu, Zn and Mn.

4. The light emitting device of claim 3, wherein the proportion of the at least one divalent metal ion selected from the group consisting of Mg, Ca, Cu, Zn and Mn is less than or same to about 0.5.

5. The light emitting device of claim 2, wherein the rare earth metals comprise at least one trivalent metal ion selected from a group consisting of Y, La and lanthanides with atomic numbers 58 to 71.

6. The light emitting device of claim 2, wherein the rare earth metals comprise at least one trivalent metal ion selected from a group consisting of Y, La, Gd and Lu.

7. The light emitting device of claim 1, wherein the luminophores comprise a divalent rare earth metal ion and a trivalent rare earth metal ion as activators in addition to Eu.

8. The light emitting device of claim 7, wherein the divalent rare earth metal ion activators are samarium ions or ytterbium ions.

9. The light emitting device of claim 7, wherein the trivalent rare earth metal ion activators are cerium ions($Ce^{3+}$).

10. The light emitting device of claim 1, wherein the luminophores are provided according to a formula $(1-x)(Sr_{3-a-b-z}Ba_aCa_bM^{II}_cEu_z)SiO_5 \cdot x \, SE_2SiO_5$,
   wherein the $M^{II}$ is at least one selected from a group consisting of Mg, Cu, Zn and Mn,
   SE is an element selected from a group consisting of Y, La and lanthanides with atomic numbers 58 to 71,

$$0 < x \le 0.2,$$

$$0 \le a \le 3, \, 0 \le b \le 0.05, \, 0 \le c \le 0.05,$$

and

$$z \le 0.25.$$

11. The light emitting device of claim 10, wherein $x \le 0.1$.

12. The light emitting device of claim 1,
   wherein the light emitting device is to emit white light by mixing light emitted from the light emitting diode and light emitted from the luminescent substances.

13. The light emitting device of claim 1, wherein the luminescent substances have a peak wavelength between approximately 560 nm and approximately 620 nm.

14. The light emitting device of claim 1, wherein the light emitting diode and the luminescent substances are formed within one package.

15. The light emitting device of claim 14, further comprising:

   a light emitting diode formed within the package,
   wherein the light emitting diode emits light of longer wavelength than the emission peak wavelength of the luminescent substances.

16. The light emitting device of claim 14, wherein the package comprises a substrate on which the light emitting diode is mounted.

17. The light emitting device of claim 16, wherein the substrate comprises a printed circuit board and a lead frame.

18. The light emitting device of claim 17, further comprising:

   a molding member to encapsulate the light emitting diode on the substrate,
   wherein the luminescent substances are distributed in the molding member.

19. The light emitting device of claim 14, wherein the package comprises a heat-sink on which the light emitting diode is mounted.

20. The light emitting device of claim 1, wherein the light emitting diode comprises a plurality of light emitting cells.


**Patentansprüche**

1. Leuchtvorrichtung, die Folgendes umfasst:

   eine Leuchtdiode; und
   lumineszierende Substanzen, die um die Leuchtdiode angeordnet sind, um wenigstens einen Teil von von der Leuchtdiode emittiertem Licht zu absorbieren und um Licht mit einer anderen Wellenlänge als der des absorbierten Lichts zu emittieren, wobei die lumineszierenden Substanzen $Eu^{2+}$-dotierte Silicatluminophore umfassen, die feste Lösungen aus gemischten Phasen zwischen Erdalkalimetall-Oxyorthosilicaten und Seltenerdmetall-Oxyorthosilicaten umfassen, die als Basisgitter für die zu Lumineszenz führende $Eu^{2+}$-Aktivierung benutzt werden.

2. Leuchtvorrichtung nach Anspruch 1, wobei die $Eu^{2+}$-dotierten Silicatluminophore gemäß einer Formel $(1-x)M^{II}_3SiO_5 \cdot x\ SE_2SiO_5$:Eu bereitgestellt werden,
   wobei das M" zweiwertige Metallionen repräsentiert, die wenigstens ein Ion umfassen, das ausgewählt ist aus einer Gruppe bestehend aus Strontiumionen und Bariumionen, und SE Seltenerdmetalle repräsentiert.

3. Leuchtvorrichtung nach Anspruch 2, wobei das M" wenigstens ein zweiwertiges Metallion umfasst, das ausgewählt ist aus einer Gruppe bestehend aus Mg, Ca, Cu, Zn und Mn.

4. Leuchtvorrichtung nach Anspruch 3, wobei der Anteil des wenigstens einen zweiwertigen Metallions, das ausgewählt ist aus einer Gruppe bestehend aus Mg, Ca, Cu, Zn und Mn, gleich oder kleiner als etwa 0,5 ist.

5. Leuchtvorrichtung nach Anspruch 2, wobei die Seltenerdmetalle wenigstens ein dreiwertiges Metallion umfassen, das ausgewählt ist aus einer Gruppe bestehend aus Y, La und Lanthaniden mit Atomzahlen von 58 bis 71.

6. Leuchtvorrichtung nach Anspruch 2, wobei die Seltenerdmetalle wenigstens ein dreiwertiges Metallion umfassen, das ausgewählt ist aus einer Gruppe bestehend aus Y, La, Gd und Lu.

7. Leuchtvorrichtung nach Anspruch 1, wobei die Luminophore ein zweiwertiges Seltenerdmetallion und ein dreiwertiges Seltenerdmetallion als Aktivatoren zusätzlich zu Eu umfassen.

8. Leuchtvorrichtung nach Anspruch 7, wobei die zweiwertigen Seltenerdmetallionen-Aktivatoren Samariumionen oder Ytterbiumionen sind.

9. Leuchtvorrichtung nach Anspruch 7, wobei die dreiwertigen Seltenerdmetallionen-Aktivatoren Ceriumionen ($Ce^{3+}$) sind.

10. Leuchtvorrichtung nach Anspruch 1, wobei die Luminophoren gemäß einer Formel $(1-x)(Sr_{3-a-b-z}Ba_aCa_bM^{II}_cEu_z)SiO_5 \cdot x\ SE_2SiO_5$ bereitgestellt werden,
   wobei M" wenigstens ein Element ausgewählt aus einer Gruppe bestehend aus Mg, Cu, Zn und Mn ist,
   SE ein Element ist, das ausgewählt ist aus einer Gruppe bestehend aus Y, La und Lanthaniden mit Atomzahlen von 58 bis 71,

$$0 < x \leq 0{,}2,$$

$$0 \le a \le 3, \ 0 \le b \le 0,05, \ 0 \le c \le 0,05,$$

und

$$z \le 0,25.$$

**11.** Leuchtvorrichtung nach Anspruch 10, wobei $x \le 0,1$ ist.

**12.** Leuchtvorrichtung nach Anspruch 1,
wobei die Leuchtvorrichtung zum Emittieren von Weißlicht durch Mischen von von der Leuchtdiode emittiertem Licht und von den lumineszierenden Substanzen emittiertem Licht dient.

**13.** Leuchtvorrichtung nach Anspruch 1, wobei die lumineszierenden Substanzen eine Spitzenwellenlänge zwischen etwa 560 nm und etwa 620 nm haben.

**14.** Leuchtvorrichtung nach Anspruch 1, wobei die Leuchtdiode und die lumineszierenden Substanzen in einem Paket ausgebildet sind.

**15.** Leuchtvorrichtung nach Anspruch 14, die ferner Folgendes umfasst:

eine in dem Paket ausgebildete Leuchtdiode,
wobei die Leuchtdiode Licht mit einer Wellenlänge emittiert, die länger ist als die Emissionsspitzenwellenlänge der lumineszierenden Substanzen.

**16.** Leuchtvorrichtung nach Anspruch 14, wobei das Paket ein Substrat umfasst, auf dem die Leuchtdiode montiert ist.

**17.** Leuchtvorrichtung nach Anspruch 16, wobei das Substrat eine Leiterplatte und einen Leiterrahmen umfasst.

**18.** Leuchtvorrichtung nach Anspruch 17, die ferner Folgendes umfasst:

ein Formelement zum Verkapseln der Leuchtdiode auf dem Substrat,
wobei die lumineszierenden Substanzen in dem Formelement verteilt sind.

**19.** Leuchtvorrichtung nach Anspruch 14, wobei das Paket einen Kühlkörper umfasst, auf dem die Leuchtdiode montiert ist.

**20.** Leuchtvorrichtung nach Anspruch 1, wobei die Leuchtdiode mehrere Leuchtzellen umfasst.

**Revendications**

**1.** Un dispositif électroluminescent comprenant;
une diode émettrice de lumière; et
substances luminescentes disposées autour de la diode émettrice de lumière pour absorber au moins une partie de la lumière émise par la diode émettrice de lumière et pour émettre de la lumière ayant une longueur d'onde différente de celle de la lumière absorbée, dans lequel les substances luminescentes comprennent luminophores de silicate dopés $Eu^{2+}$ comprenant des solutions solides de phases mixtes entre oxyorthosilicates de métal de terre alcaline et oxyorthosilicates de métal de terre rare utilisés comme réseaux de base pour l'activation de $Eu^{2+}$ conduisant à la luminescence.

**2.** Le dispositif électroluminescent selon la revendication 1, dans lequel les luminophores de silicate dopés $Eu^{2+}$ sont fournis conformément à une formule $(1-x)M^{II}_3SiO_5 \cdot xSE_2SiO_5{:}Eu$,
dans lequel, le $M^{II}$ représente des ions métalliques divalents comprenant au moins one choisi dans un groupe constitué d'ions de strontium et d'ions de baryum et SE représente les métaux des terres rares.

3. Le dispositif électroluminescent selon la revendication 2, dans lequel le $M^{II}$ comprend au moins un ion métallique divalent choisi dans le groupe constitué par Mg, Ca, Cu, Zn et Mn.

4. Le dispositif électroluminescent selon la revendication 3, dans lequel la proportion du au moins un ion métallique divalent choisi dans le groupe constitué par Mg, Ca, Cu, Zn et Mn est inférieur ou égal à environ 0,5.

5. Le dispositif électroluminescent selon la revendication 2, dans lequel les métaux des terres rares comprennent au moins un ion métallique trivalent choisi parmi un groupe constitué par Y, La et des lanthanides avec un numéro atomique 58-71.

6. Le dispositif électroluminescent selon la revendication 2, dans lequel les métaux des terres rares comprennent au moins un ion métallique trivalent choisi parmi un groupe constitué par Y, La, Gd et Lu.

7. Le dispositif électroluminescent selon la revendication 1, dans lequel les luminophores comprennent un ion divalent métallique de terres rares et un ion trivalent métallique de terres rares comme activateurs en outre à Eu.

8. Le dispositif électroluminescent selon la revendication 7, dans lequel les activateurs ion divalent métallique de terres rares sont ions de samarium ou ions d'ytterbium.

9. Le dispositif électroluminescent selon la revendication 7, dans lequel les activateurs ion trivalent métallique de terres rares sont des ions de cérium ($Ce^{3+}$).

10. Le dispositif électroluminescent selon la revendication 1, dans lequel les luminophores sont fournis conformément à une formule $(1-x)(Sr_{3-a-b-z}Ba_aCa_bM^{II}{}_cEu_z)SiO_5 \cdot x\ SE_2SiO_5$,
dans lequel le $M^{II}$ est au moins un choisi parmi un groupe constitué de Mg, Cu, Zn et Mn, SE est un élément choisi dans un groupe constitué par Y, La et les lanthanides de numéro atomique 58 à 71,

$$0 < x \le 0.2,$$

$$0 \le a \le 3,\ 0 \le b \le 0.05,\ 0 \le c \le 0.05,$$

et

$$z \le 0.25.$$

11. Le dispositif électroluminescent selon la revendication 10, dans lequel $x \le 0.1$.

12. Le dispositif électroluminescent selon la revendication 1,
dans lequel le dispositif électroluminescent est pour émettre de la lumière blanche en mélangeant la lumière émise par la diode et de la lumière émise par les substances luminescentes.

13. Le dispositif électroluminescent selon la revendication 1, dans lequel les substances luminescentes présentent une longueur d'onde maximale entre environ 560 nm et environ 620 nm.

14. Le dispositif électroluminescent selon la revendication 1, dans lequel la diode émettrice de lumière et les substances luminescentes sont formés dans un boitier.

15. Le dispositif électroluminescent selon la revendication 14, comprenant en outre:

une diode émettrice de lumière formée dans le boitier,
dans lequel la diode émettrice de lumière émet de la lumière avec une longueur d'onde plus longue que la longueur d'onde d'émission de crête des substances luminescentes.

**16.** Le dispositif électroluminescent selon la revendication 14, dans lequel le boitier comprend un substrat sur lequel la diode électroluminescente est montée.

**17.** Le dispositif électroluminescent selon la revendication 16, dans lequel le substrat comprend une carte de circuit imprimé et une grille de connexion.

**18.** Le dispositif électroluminescent selon la revendication 17, comprenant en outre:

un élément de moulage pour encapsuler la diode émettrice de lumière sur le substrat,
dans lequel les substances luminescentes sont réparties dans l'élément de moulage.

**19.** Le dispositif électroluminescent selon la revendication 14, dans lequel le boitier comprend un dissipateur de chaleur sur lequel la diode électroluminescente est montée.

**20.** Le dispositif électroluminescent selon la revendication 1, dans lequel la diode émettrice de lumière comprend une pluralité de cellules émettant de la lumière.

[Fig. 1]

[Fig. 2]

[Fig. 3]

[Fig. 4]

[Fig. 5]

[Fig. 6]

[Fig. 7]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20080083906 A1
- US 2006261309 A1
- US 2009072255 A1